# EUROPÄISCHE PATENTSCHRIFT

(11) **EP 0 735 689 B1**
(45) Veröffentlichungstag und Bekanntmachung des Hinweises auf die Patenterteilung: **06.09.2000**
(21) Anmeldenummer: 96103410.5
(22) Anmeldetag: 05.03.1996
(51) Int. Cl.: H03L 1/00, H03K 3/011

(54) **Monolithisch integrierte spannungsgesteuerte Oszillatorschaltung**
Monolithic integrated voltage controlled oscillator circuit
Circuit intégré monolithique d'oscillateur commandé par une tension

(30) Priorität: 28.03.1995 DE 19511402
(43) Veröffentlichungstag der Anmeldung: 02.10.1996
(73) Patentinhaber: SIEMENS AKTIENGESELLSCHAFT, 80333 München (DE)
(72) Erfinder: Neudecker, Albrecht, Dipl.-Ing., 81379 München (DE)

(56) Entgegenhaltungen:
- US-E- R E34 317
- IBM TECHNICAL DISCLOSURE BULLETIN, Bd. 33, Nr. 5, 1.Oktober 1990, NEW YORK US, Seiten 260-262, XP000107456 "HIGH-FREQUENCY VOLTAGE-CONTROLLED OSCILLATOR"
- IEEE INTERNATIONAL SOLID STATE CIRCUITS CONFERENCE, Bd. 31, 17.Februar 1988, NEW YORK US, Seite 22/23, 283 XP000031769 TING-PING LIU ET AL: "A 250MHZ MONOLITHIC VOLTAGE-CONTROLLED OSCILLATOR"

## Beschreibung

Phasendetektoren, wie sie in Phasenregelschleifen (PLLs) für die Taktrückgewinnung aus einem Datensignal eingesetzt werden, liefern ein Ausgangssignal, das einem Phasenunterschied zwischen ihren beiden Eingangssignalen entspricht, das indessen für die Taktrückgewinnung nicht mehr hilfreich ist, wenn gleichzeitig der Frequenzunterschied zwischen den beiden Eingangssignalen des Phasendetektors zu groß ist. Damit die Phasenregelschleife dennoch auf die Taktfrequenz einrasten kann, muß der Frequenzbereich des darin enthaltenen spannungsgesteuerten Oszillators (VCO) möglichst klein sein.

Der Frequenzbereich eines in ECL-Technologie integrierten, spannungsgesteuerten Oszillators hängt stark von der Betriebstemperatur des Chips und von fertigungsbedingten Streuungen der Halbleiterparameter ab. Um sicher zu gehen, daß der Oszillator auf der gewünschten Frequenz schwingen kann, wird der durchstimmbare Frequenzbereich so groß ausgelegt, daß die gewünschte Frequenz nicht nur im Normalfall, sondern auch im schlechtesten Fall sicher erreicht werden kann; der Durchstimmbereich muß dazu entsprechend groß (größer als eine Oktave) sein. Dann ist aber nicht mehr sicher, daß die Phasenregelschleife gerade auf die richtige Frequenz einrastet; sie könnte stattdessen beispielsweise auch bei der doppelten Frequenz einrasten.

Man kann dem entgegenwirken, indem man zum Stellsignal des spannungsgesteuerten Oszillators das Stellsignal einer Referenz-Phasenregelschleife addiert; dies setzt einerseits allerdings einen entsprechenden schaltungstechnischen Aufwand für einen solchen Referenztakt voraus, wobei dieser andererseits zu unerwünschten Schwebungserscheinungen führen kann. Aus der US-E RE34,317 ist bereits eine monolithisch integrierte spannungsgesteuerte Oszillatorschaltung bekannt, bei der ein spannungsgesteuerter Oszillator und ein zusätzlicher, gleichartiger Oszillator auf demselben Chip vorgesehen sind. Ferner wird aus der Schwingungsfrequenz des zusätzlichen Oszillators ein zum Temperatur- bzw. Parametereinfluß auf die Oszillatorfrequenz gegensinniges Zusatz-Steuersignal für den spannungsgesteuerten Oszillator abgeleitet. Das Zusatz-Steuersignal wird durch den Vergleich der Schwingungsfrequenz des zusätzlichen Oszillators mit der Frequenz eines mitintegrierten, stabilen Referenzoszillators in einem mitintegrierten Phasenkomperator gewonnen.

Die Erfindung zeigt nun einen Weg zu einem noch weniger schaltungsaufwendigen spannungsgesteuerten Oszillator hoher Genauigkeit.

Die Erfindung betrifft eine monolithisch integrierte spannungsgesteuerte Oszillatorschaltung gemäß dem Oberbegriff des Anspruchs 1 und erfindungsgemäß dadurch gekennzeichnet, daß der zusätzliche Oszillator jedoch kein spannungsgesteuerter Oszillator ist, und daß der Ausgang des zusätzlichen Oszillators über eine Kettenschaltung eines Monoflops und eines nachfolgenden Tiefpasses mit einem Zusatz-Steuereingang des spannungsgesteuerten Oszillators verbunden ist.

Die Erfindung, die sich nicht eines Referenztaktes als solchen bedient, sondern sich lediglich eine daraus abgeleitete Information über die Frequenz eines in gleicher Weise wie der spannungsgesteuerte Oszillator temperatur- und parameterabhängigen Referenzoszillators zunutze macht, wobei die Nennfrequenzen der beiden Oszillatoren auch ganz unterschiedlich sein können, ermöglicht vorteilhafterweise eine einfache Kompensation von parameter- bzw. temperaturbedingten Frequenzabweichungen eines monolithisch integrierten spannungsgesteuerten Oszillators.

Weitere Besonderheiten der Erfindung werden aus der nachfolgenden näheren Erläuterung eines Ausführungsbeispiels anhand der Zeichnungen ersichtlich. Dabei zeigt
- FIG 1: ein Blockschaltbild eines Ausführungsbeispiels einer monolithisch integrierten spannungsgesteuerten Oszillatorschaltung gemäß der Erfindung;
- FIG 2 bis FIG 6: zeigen schaltungstechnische Einzelheiten dazu.

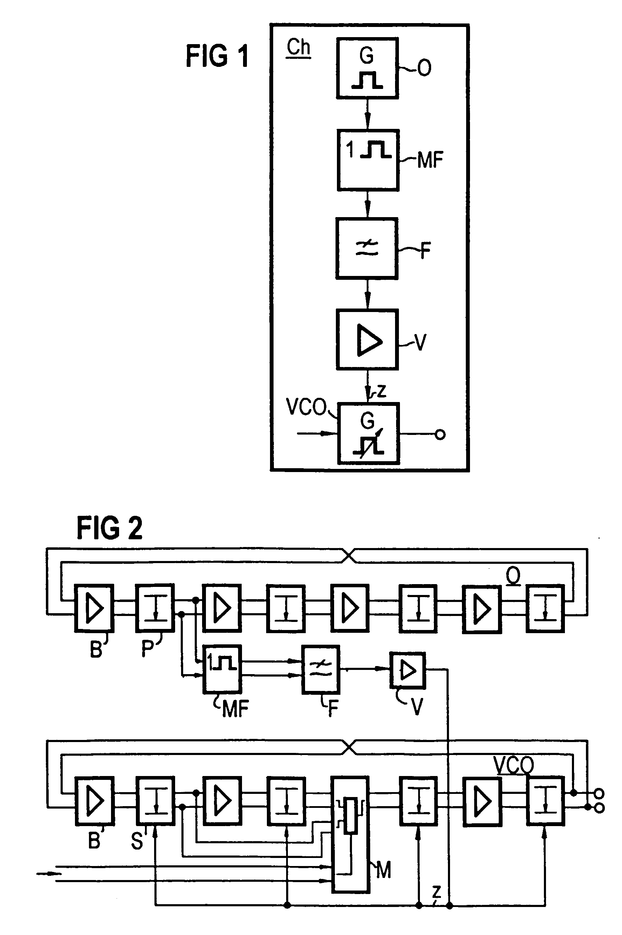

Die Zeichnung FIG 1 zeigt schematisch in einem zum Verständnis der Erfindung erforderlichen Umfang eine monolithisch auf einem Chip Ch integrierte spannungsgesteuerte Oszillatorschaltung. Dabei ist zusätzlich zu dem eigentlichen spannungsgesteuerten Oszillator VCO auf demselben Chip Ch ein gleichartiger Oszillator O vorgesehen, der nicht von aussen spannungsgesteuert ist und dessen Schwingungsfrequenz in prinzipiell gleicher Weise wie diejenige des spannungsgesteuerten Oszillators VCO von der Betriebstemperatur des Chips Ch und den Fertigungsparametern abhängt. Aus der Schwingungsfrequenz des zusätzlichen Oszillators O wird nun ein zum Temperatur- bzw. Parametereinfluß auf die Oszillatorfrequenz des spannungsgesteuerten Oszillators VCO gegensinniges Zusatz-Steuersignal für den spannungsgesteuerten Oszillator VCO abgeleitet, wozu gemäß FIG 1 der Ausgang des zusätzlichen Oszillators O über die Kettenschaltung eines Monoflops MF, eines Tiefpasses F und eines Verstärkers V mit einem Zusatz-Steuereingang z des spannungsgesteuerten Oszillators VCO verbunden ist. Dabei werden die Ausgangsimpulse des Referenz-Oszillators O durch das Monoflop MF jeweils auf einen festen Wert (etwa 1/4 der Periodendauer bei Normalparametern und mittlerer Temperatur) verlängert, so daß nunmehr das Puls/Pause-Verhältnis der Rechteckimpulsfolge von der Schwingungsfrequenz des Oszillators O abhängt. Mit dem nachfolgenden Tiefpaß F wird der Gleichanteil dieser Rechteckimpulsfolge herausgefiltert; nach einer Verstärkung im nachfolgenden Verstärker V dient der verstärkte Gleichanteil dann als etwaigen Frequenzänderungen entgegenwirkendes Stellsignal für den spannungsgesteuerten Rechteckoszillator VCO.

Ein weitere schaltungstechnische Einzelheiten zeigendes Blockschaltbild einer solchen monolithisch integrierten spannungsgesteuerten Oszillatorschaltung gemäß der Erfindung ist in FIG 2 dargestellt. Gemäß FIG 2 ist der Referenz-Oszillator O mit einer invertierend rückgekoppelten Kettenschaltung von Bufferschaltungen B und Pegelschiebern P gebildet. In prinzipiell gleichartiger Weise ist auch der eigentliche spannungsgesteuerte Rechteckoszillator VCO mit einer positiv rückgekoppelten Kettenschaltung von Bufferschaltungen B und Pegelschiebern S gebildet, wobei hier jedoch in der Kettenschaltung auch ein Steuerglied M zur Frequenzsteuerung vorgesehen ist. Zwischen dem Referenz-Oszillator O und dem Zusatz-Steuereingang z des spannungsgesteuertem Oszillators VCO liegt wiederum eine Kettenschaltung aus Monoflop MF, Tiefpass F und Verstärker V.

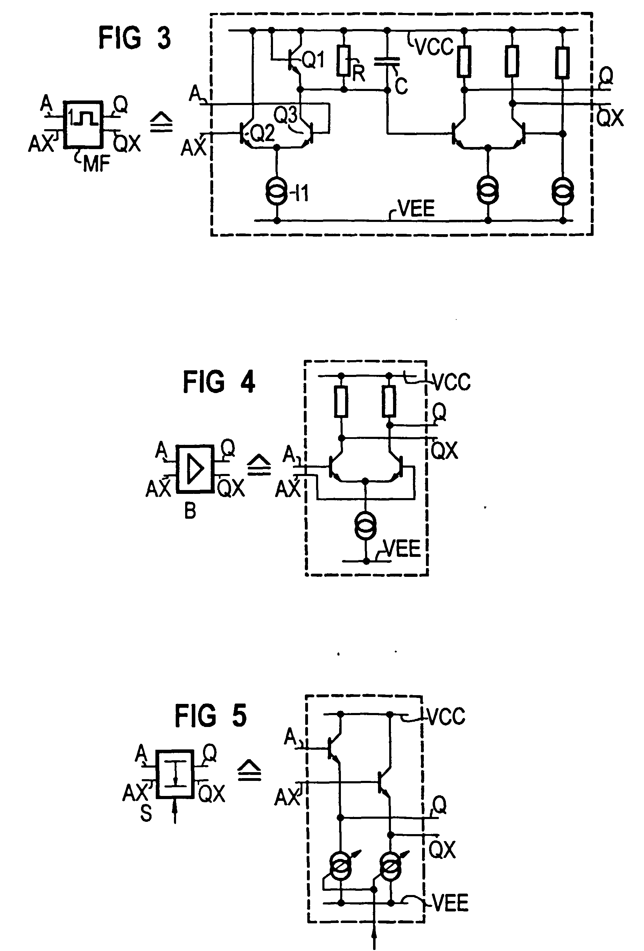

Die ECL-Bufferschaltungen B können in der aus FIG 4 ersichtlichen Weise realisiert sein und ECL-Pegelschieber S in der aus FIG 5 ersichtlichen Weise; von den Pegelschiebern S gemäß FIG 5 unterscheiden sich die Pegelschieber P lediglich dadurch, daß in ihnen die Querstromquellen nicht steuerbar sind. Die Laufzeit eines ECL-Puffers B hängt jeweils vom Querstrom des vorangehenden Pegelschiebers P bzw. S ab: Je größer der Querstrom ist, desto kleiner ist (mit gewissen Grenzen) die Laufzeit. Das läßt sich ausnutzen, um die Frequenz des Oszillators zu verändern.

Das monostabile Flip-Flop MF (in FIG 1 und FIG 2) kann in der aus FIG 3 ersichtlichen Weise realisiert sein. Die zeitbestimmenden Elemente des ECL-Monoflops MF gemäß FIG 3 sind der Widerstand R und die Kapazität C. Sie müssen so realisiert sein, daß sie möglichst unabhängig von Fertigungsparametern sind, was z.B. mit einem großflächigen Widerstand und der Ausnutzung der Kapazität zwischen zwei Verdrahtungsebenen im Chip erreicht werden kann. Der Transistor Q1 dient dazu, die Spannung über dem RC-Glied zu begrenzen, so daß der Kondensator C immer auf eine definierte Spannung aufgeladen wird. Die Temperaturabhängigkeit läßt sich ggf. kompensieren, indem man in dem in FIG 3 skizzierten Monoflop die Steuerspannung des anderen Transistors des Ausgangspuffers entsprechend nachführt, was, ohne daß dies hier noch weiter erläutert werden muß, durch eine entsprechende temperaturabhängige Steuerung der zugehörigen Stromquelle erreicht werden kann.

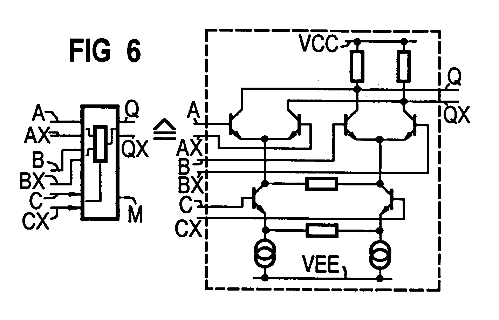

Das im spannungsgesteuerten Rechteckoszillator VCO (in FIG 1 und FIG 2) vorgesehene Steuerglied M zur Frequenzsteuerung kann in der aus FIG 6 ersichtlichen Weise realisiert sein. Gemäß FIG 6 ist das frequenzsteuernde Glied M ein ECL-Analogsignal-Multiplexer, dessen beide Eingänge A/AX und B/BX im spannungsgesteuerten Rechteck-Oszillator VCO gemäß FIG 2 an zwei (über eine Bufferschaltung B) aufeinanderfolgende Pegelschieber S angeschlossen sind und dessen Steuereingang C/CX den Frequenzsteuereingang des spannungsgesteuerten Oszillators VCO (in FIG 1 und FIG 2) bildet. Mit der zwischen den Steuereingangsanschlüssen C und CX zugeführten Spannung läßt sich einstellen, wie stark sich das am Eingang A/AX auftretende Signal oder das am Eingang B/BX auftretende Signal am Ausgang Q/QX auswirkt.

## Patentansprüche

1. Monolithisch integrierte spannungsgesteuerte Oszillatorschaltung, wobei ein spannungsgesteuerter Oszillator (VCO) und ein zusätzlicher, gleichartiger Oszillator (O) auf demselben Chip (Ch) vorgesehen sind, wobei aus der Schwingungsfrequenz des zusätzlichen Oszillators (O) ein zum Temperatur- bzw. Parametereinfluß auf die Oszillatorfrequenz gegensinniges Zusatz-Steuersignal für den spannungsgesteuerten Oszillator abgeleitet wird,
**dadurch gekennzeichnet**,
daß der zusätzliche Oszillator (O) jedoch kein spannungsgesteuerter Oszillator ist, und daß der Ausgang des zusätzlichen Oszillators (O) über eine Kettenschaltung eines Monoflops (MF) und eines nachfolgenden Tiefpasses (F) mit einem Zusatz-Steuereingang (z) des spannungsgesteuerten Oszillators (VCO) verbunden ist.

2. Spannungsgesteuerte Oszillatorschaltung nach Anspruch 1,
**dadurch gekennzeichnet**,
daß die beiden Oszillatoren (O) VCO) jeweils mit einer rückgekoppelten Kettenschaltung von ECL-Bufferschaltungen (B) und ECL-Pegelschiebern (P; S) gebildet sind.

3. Spannungsgesteuerte Oszillatorschaltung nach Anspruch 2 , **dadurch gekennzeichnet,**
daß der spannungsgesteuerte Oszillator (VCO) ein spannungsgesteuerter Rechteckoszillator ist; und daß ein im spannungsgesteuerten Rechteckoszillator (VCO) vorgesehenes Steuerglied (M) zur Frequenzsteuerung ein ECL-Analogsignal-Multiplexer ist, dessen beide Eingänge (A/AX, B/BX) an zwei über eine Bufferschaltung (B) aufeinanderfolgende Pegelschieber (S) angeschlossen sind und dessen Steuereingang (C/CX) den Frequenzsteuereingang des spannungsgesteuerten Oszillators (VCO) bildet.

## Claims

1. Monolithically integrated voltage controlled oscillator circuit, in which a voltage controlled oscillator (VCO) and an additional, identical oscillator (O) are provided on the same chip (Ch), and in which an additional control signal which is in the opposite sense to the temperature and parameter influence on the oscillator frequency is derived from the oscillation frequency of the additional oscillator (O), for the voltage controlled oscillator,
characterized
in that the additional oscillator (O) is, however, not a voltage controlled oscillator, and in that the output of the additional oscillator (O) is connected via a concatenated circuit comprising a monostable multivibrator (MF) and a downstream low-pass filter (F) to an additional control input (z) of the voltage controlled oscillator (VCO).

2. Voltage controlled oscillator circuit according to Claim 1,
characterized
in that the two oscillators (O, VCO) are each formed with a concatenated circuit, with feedback, of ECL buffer circuits (B) and ECL level shifters (P; S).

3. Voltage controlled oscillator circuit according to Claim 2,
characterized
in that the voltage controlled oscillator (VCO) is a voltage controlled square-wave oscillator; and in that a control element (M) which is provided in the voltage controlled square-wave oscillator (VCO), for frequency control, is an ECL analogue signal multiplexer, whose two inputs (A/AX, B/BX) are connected to two level shifters (S) which follow one another via a buffer circuit (B), and whose control input (C/CX) forms the frequency control input of the voltage controlled oscillator (VCO).

## Revendications

1. Circuit intégré monolithique d'oscillateur commandé en tension, dans lequel un oscillateur (VCO) commandé en tension et un oscillateur supplémentaire, du même type (O) sont prévus sur la même puce (Ch), dans lequel à partir de la tension de vibration de l'oscillateur supplémentaire (O) un signal de commande additionnel, en sens inverse par rapport à l'effet de température resp. à l'effet de paramètre sur la fréquence de l'oscillateur, est dérivé pour l'oscillateur commandé en tension, caractérisé en ce que l'oscillateur supplémentaire (O) n'est cependant pas un oscillateur commandé en tension, et en ce que la sortie de l'oscillateur supplémentaire (O) est reliée par un circuit en chaîne d'une bascule monostable (MF) et d'un passe-bas consécutif (F) à une entrée de commande additionnelle (z) de l'oscillateur commandé en tension (VCO).

2. Circuit d'oscillateur commandé en tension selon la revendication 1, caractérisé en ce que les deux oscillateurs (O, VCO) sont formés à chaque fois avec un circuit en chaîne rétroactif de circuits tampons à couplage d'émetteur (B) et de tiroirs de niveau à couplage d'émetteur (P; S).

3. Circuit d'oscillateur commandé en tension selon la revendication 2, caractérisé en ce que l'oscillateur commandé en tension (VCO) est un oscillateur rectangulaire commandé en tension, et en ce qu'un organe de régulation (M) prévu dans l'oscillateur rectangulaire commandé en tension (VCO) pour commander la fréquence est un multiplexeur à signal analogique à couplage d'émetteur, dont les deux entrées (A/AX, B/BX) sont raccordées à deux tiroirs de niveau (S) se succédant au moyen d'un circuit tampon (B) et dont l'entrée de commande (C/CX) forme l'entrée de commande de fréquence de l'oscillateur commandé en tension (VCO).
